# EUROPEAN PATENT APPLICATION

(11) **EP 4 260 966 A1**
(43) Date of publication of application: **18.10.2023**
(21) Application number: 21902935.2
(22) Date of filing: 25.08.2021
(51) Int. Cl.: B22F 5/04, B22F 7/08, C30B 1/08, C30B 11/14, C30B 13/06, C22C 1/04, C22C 19/05, F01D 25/00, B33Y 10/00, B33Y 80/00, B22F 10/28, B22F 10/366, B22F 10/38, F02C 7/00

(54) **PRODUCTION METHOD FOR TURBINE COMPONENT, REPAIRING METHOD, AND TURBINE COMPONENT**

(30) Priority: 10.12.2020 JP 2020204771
(71) Applicant: Toshiba Energy Systems & Solutions Corporation, Saiwai-ku Kawasaki-shi Kanagawa 2120013 (JP); National Institute for Materials Science, Tsukuba-shi, Ibaraki 305-0047 (JP)
(72) Inventor: HINO, Takehisa, Kawasaki-shi, Kanagawa 212-0013 (JP); HARADA, Hiroshi, Tsukuba-shi, Ibaraki 305-0047 (JP); KAWAGISHI, Kyoko, Tsukuba-shi, Ibaraki 305-0047 (JP); OSADA, Toshio, Tsukuba-shi, Ibaraki 305-0047 (JP); YOKOKAWA, Tadaharu, Tsukuba-shi, Ibaraki 305-0047 (JP); KOIZUMI, Yutaka, Tsukuba-shi, Ibaraki 305-0047 (JP); OSAWA, Makoto, Tsukuba-shi, Ibaraki 305-0047 (JP); TANAKA, Toru, Tokyo 105-0023 (JP); NAKANO, Hideshi, Tokyo 105-0023 (JP); SUMIYA, Rie, Kawasaki-shi, Kanagawa 212-0013 (JP); KITAYAMA, Kazuhiro, Kawasaki-shi, Kanagawa 212-0013 (JP); SAKAI, Yoshiaki, Kawasaki-shi, Kanagawa 212-0013 (JP); SAKAMOTO, Akihiro, Kawasaki-shi, Kanagawa 212-0013 (JP)
(74) Representative: Hoffmann Eitle
(86) International application number: PCT/JP2021/031134
(87) International publication number: WO 2022/123830

(57) **Abstract**

There is provided a method for manufacturing a turbine component which enables obtaining a single crystal structure more easily and manufacturing a good turbine component. In the seed crystal placing step, the seed crystal is placed on the surface of the base in a manner that a first direction along <001> of the seed crystal has an angle within 15 degrees in absolute value in relation to a laminating direction. In the shaped layer forming step, scanning is performed in a manner that the scan direction has an angle within 20 degrees in absolute value in relation to a second direction being <001> orthogonal to the first direction of the seed crystal.

## Description

### FIELD

Embodiments described herein relate generally to a method for manufacturing a turbine component, a method for repairing the same, and a turbine component.

### BACKGROUND

A greater efficiency of power generation equipment is recently sought in view of carbon dioxide discharge reduction, and an efficiency of a gas turbine has been improved by increasing a temperature of combustion gas. Temperature increase of the combustion gas can be achieved by improving a creep strength of a turbine blade material and improving a cooling performance.

As the turbine blade material, a conventional cast alloy which contains numerous crystals with different directions is replaced with a unidirectional solidification alloy whose crystal grains are oriented in a turbine blade longitudinal direction where a creep strength is required because of a centrifugal stress and whose crystal grains are strengthened by orienting [001] direction of a face-centered cubic lattice, and with a single crystal alloy whose [001] direction of a face-centered cubic lattice is oriented in a turbine blade longitudinal direction, so that the turbine blade material is strengthened and improved.

In addition, as for cooling, a simple cooling method of flowing cooling air through a long hole made in a direction of a centrifugal axis is replaced with a cooling method called return flow in which cooling air flows complexly, to thereby improve a cooling performance.

A complex cooling structure called return flow is manufactured by a method in which casting is performed in a state where a ceramic component called a core is set and thereafter the core is melted by using an alkaline solution such as sodium hydroxide, but the cooling structure is subjected to restraints by a strength or the like of the core.

Recently, a technique called an additive manufacturing method is being developed. Since additive manufacturing enables manufacturing of a structure which has been difficult to be manufactured, a cooling structure unique to additive manufacturing is being suggested also in the field of a turbine blade.

In the additive manufacturing method, in general, since a crystal is grown on a base such as a stainless plate having a structure of an equiaxial crystal, numerous crystal grains with different directions grow, causing generation of a crystal grain boundary. The crystal grain boundary affects a mechanical property, and it is known that existence of the crystal grain boundary decreases a high-temperature creep strength and a fatigue strength.

In the additive manufacturing method, a method for manufacturing a single crystal by using a seed crystal is suggested, by which a shaped object without a grain boundary can be obtained. In this technique, shaping is performed in a state where a seed crystal surface is at the same level as a base. There is a possibility that unevenness of powder amounts occurs in application of the powder, and good crystals may not be able to be shaped in shaping thereafter, but it is alleged that a good single crystal can be obtained by polishing a surface of a seed crystal and placing the seed crystal in a manner that a direction of a linear mark by polishing intersects a moving direction of powder grains by a recoater to thereby make the powder easy to remain at a time of forming a shaped layer.

### PRIOR ART DOCUMENT

### PATENT DOCUMENT

Patent Document 1: US-20130280059-A1
Patent Document 2: Patent Publication No. 6344004

### SUMMARY

### PROBLEMS TO BE SOLVED BY THE INVENTION

However, in utilizing a linear mark by polishing, there is a possibility that powder slides when the recoater moves, and there is also a possibility that the powder unevenly remains depending on a state of the linear mark by polishing.

Hence, an object of the present invention is to provide a method for manufacturing a turbine component which enables obtaining a single crystal structure more easily compared with a conventional method and manufacturing a good turbine component, a method for repairing the turbine component and a tip portion or the like of a blade having the single crystal structure, and a repair component.

### MEANS TO SOLVE THE PROBLEM

A method for manufacturing a turbine component of an embodiment includes a seed crystal placing step and a shaped layer forming step, and the turbine component is manufactured by laminating shaped layers on a surface of a base in a laminating direction. In the seed crystal placing step, a seed crystal is placed on the surface of the base. In the shaped layer forming step, after powder of a constituent constituting the shaped layer is put on the surface of the base to cover the seed crystal, an energy beam is irradiated to the powder put on the surface of the base by scanning in a scan direction to thereby form the shaped layer. Here, the seed crystal, being a single crystal, is metal having a face-centered cubic crystal structure or a structure where an L1₂ phase is coherently precipitated in a face-centered cubic crystal. In the seed crystal placing step, the seed crystal is placed on the surface of the base in a manner that a first direction along <001> of the seed crystal has an angle within 15 degrees in absolute value in relation to the lamination direction forming step, scanning is performed in a manner that the scan direction has an angle within 20 degrees in absolute value in relation to a second direction being <001> orthogonal to the first direction of the seed crystal.

### BRIEF DESCRIPTION OF THE DRAWINGS

FIG. 1 is a view schematically illustrating a method for manufacturing a turbine component according to an embodiment.
FIG. 2 is a view illustrating a positional relationship between a seed crystal and an energy beam in Example 1.
FIG. 3 is a photograph illustrating a sectional structure of a laminated shaped material obtained by Example 1.
FIG. 4 is a view illustrating a positional relationship between a seed crystal and an energy beam in Example 2.
FIG. 5 is a photograph illustrating a sectional structure of a laminated shaped material obtained by Example 2.
FIG. 6 is a view illustrating a positional relationship between a seed crystal and an energy beam in Example 3.
FIGS. 7 are IPF maps of a crystal obtained by Example 3.
FIG. 8 is a view illustrating a positional relationship between a seed crystal and an energy beam in Comparative Example.
FIGS. 9 are IPF maps of a crystal obtained by Comparative Example.
FIG. 10 is a view schematically illustrating an example of a turbine component according to the embodiment.

### DETAILED DESCRIPTION

### [A] Turbine Component

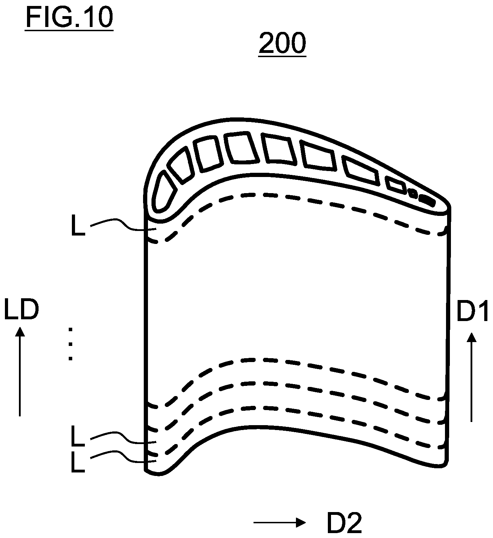

FIG. 10 is a view schematically illustrating an example of a turbine component according to an embodiment.

As illustrated in FIG. 10, a turbine component 200 is, for example, a turbine blade. The turbine component 200 is manufactured by laminating a plurality of shaped layers L in a lamination direction LD by an additive manufacturing technology (three-dimensional laminating and shaping technology), details being described later. Here, the lamination direction LD runs along a longitudinal direction of the turbine component 200.

### [B] Method for Manufacturing Turbine Component

Hereinafter, a method for manufacturing the turbine component according to the embodiment will be described with reference to the drawings.

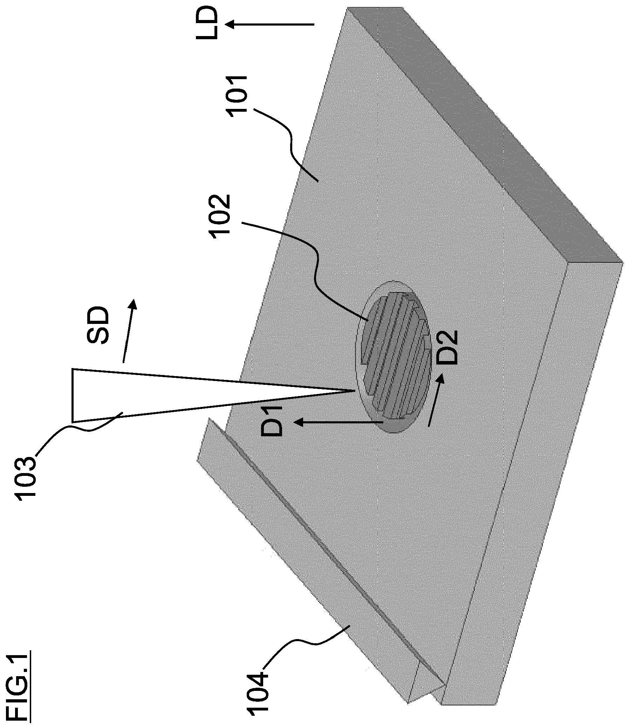

FIG. 1 is a view schematically illustrating the method for manufacturing the turbine component 200 of the embodiment. In FIG. 1, a reference numeral 101 indicates a base, a reference numeral 102 indicates a single crystal, a reference numeral 103 indicates an energy beam (for example, a laser beam, an electron beam, or the like), and a reference numeral 104 indicates a recoater.

### [B-1] Seed Crystal Placing

In manufacturing the turbine component 200, first, the seed crystal 102 is placed on a surface of the base 101 as illustrated in FIG. 1 (seed crystal placing step)

The seed crystal 102 is, for example, single crystal metal having a face-centered cubic crystal structure. The seed crystal 102 may be metal having a structure where an L1₂ phase is coherently precipitated in a face-centered cubic crystal. In general, it is known that a primary crystal direction is <001> (= [100], [010], [001] or the like) in a cubic crystal system.

Placing of the seed crystal 102 is performed by embedding the seed crystal 102 in the base 101 in a manner that a first direction D1 (for example, direction [001]) along <001> of the seed crystal 102 has an angle within 15 degrees in absolute value, preferably within 5 degrees in absolute value, in relation to a lamination direction LD (direction orthogonal to the surface of the base 101). Note that it is further preferable that the seed crystal 102 is placed in a manner that the first direction D1 along <001> of the seed crystal 102 is in parallel to the lamination direction LD. As the seed crystal 102, the same alloy as the alloy to be laminated (for example, a nickel group alloy) can be used. In other words, a material of the seed crystal 102 is the same as a constituent constituting the shaped layer L, for example.

### [B-2] Shaped Layer Forming

Next, after putting powder (not illustrated) of a constituent constituting the shaped layer L (see FIG. 10) on the surface of the base 101 in a manner to cover the seed crystal 101, an energy beam 103 is irradiated on the powder put on the surface of the base 101 by scanning in a scan direction SD (direction orthogonal to the lamination direction LD) (see FIG. 1), to thereby form the shaped layer L (see FIG. 10) (shaped layer forming step).

More specifically, by moving the recoater 104 horizontally, the powder of a substance constituting a desired alloy (for example, a nickel group alloy) to be laminated is put in a manner to cover an upper surface of the seed crystal 102. Then, scanning by the energy beam 105 is carried out in the scan direction SD under a vacuum atmosphere or an inert gas atmosphere. The energy beam 105 has energy capable of melting the powder and is irradiated in correspondence with a shape of a shaped object, so that the powder put on the surface of the base 101 is selectively melted and bonded. The scan direction SD in which the scanning by the energy beam 105 is performed has an angle within 20 degrees in absolute value, preferably has an angle within 10 degrees in absolute value in relation to a second direction D2 being <001> orthogonal to the first direction D1 of the seed crystal (when the first direction D1 is the direction [001], the second direction D2 is, for example, a direction [010] or a direction [100]). Note that it is further preferable that the second direction D2 of the seed crystal 102 (D2 in the drawing) is parallel to the scan direction SD.

As illustrated in FIG. 1, in the embodiment, by embedding the seed crystal 102 in the base 101 and making the second direction D2 (for example, the direction [010] or the direction [100]) of the embedded seed crystal 102 almost parallel to the scan direction SD of the energy beam 103, epitaxial growth of a laminated shaped material can be enhanced.

### [C] Summary

By the above method, it is possible to obtain the shaped material having the single crystal structure, without setting the surface of the seed crystal 102 at the same level as a level of the base 101. Further, by matching the scan direction of the energy beam 103 and a placing direction of the seed crystal 102, manufacturability of the single crystal can be improved.

Therefore, by forming the laminated shaped material in a state where the second direction D2 (for example, the direction [010] or the direction [100]) of the seed crystal 102 is made almost parallel to the scan direction SD of the energy beam 103 to thereby manufacture the turbine component 200 of a predetermined shape, a single crystal structure can be obtained more easily than ever before, and it is possible to manufacture a good turbine component 200.

Note that the method described above can be applied also to repairing of the turbine component 200. More specifically, after implementation of the seed crystal placing step in which a seed crystal 102 is placed on a surface of a portion to be repaired in the turbine component 200 instead of a base 101, the shaped layer forming step is carried out similarly to the above, whereby repairing of the turbine component 200 can be performed.

### [D] Examples

### (Example 1)

In Example 1, a material having a metal composition shown in Table 1 was used as shaping powder. Additionally, a single crystal material having the same composition as that of the shaping powder was used as a seed crystal.

**[Table 1]**

| Cr | Mo | W | Al | Hf | Zr | Ta | Si | c | B | Ni |
|---|---|---|---|---|---|---|---|---|---|---|
| 9.0 | 0.6 | 7.6 | 5.4 | 0.05 | 0.03 | 10.0 | 0.04 | 0.08 | 0.015 | Remainder |

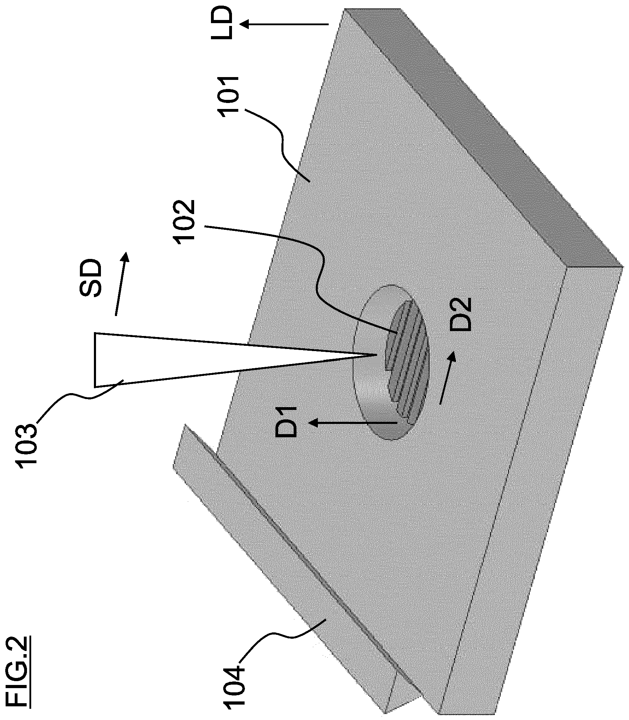

Here, a direction of a seed crystal 102 was measured in advance by a back-reflection Laue method. Then, as schematically illustrated in FIG. 2, the seed crystal 102 was embedded on a base 101 in a manner that a first direction D1 (for example, a direction [001]) along <001> of the seed crystal 102 became a lamination direction LD and that a second direction D2 (for example, a direction [010] or a direction [100]) being <001> orthogonal to the first direction D1 of the seed crystal 102 was in parallel to a scan direction SD of an energy beam 103. When the seed crystal 102 was embedded, the seed crystal 102 was set in a manner that an upper surface of the seed crystal 102 was in parallel to a base 101 plane and was lower than the surface of the base 101 by 100 µm.

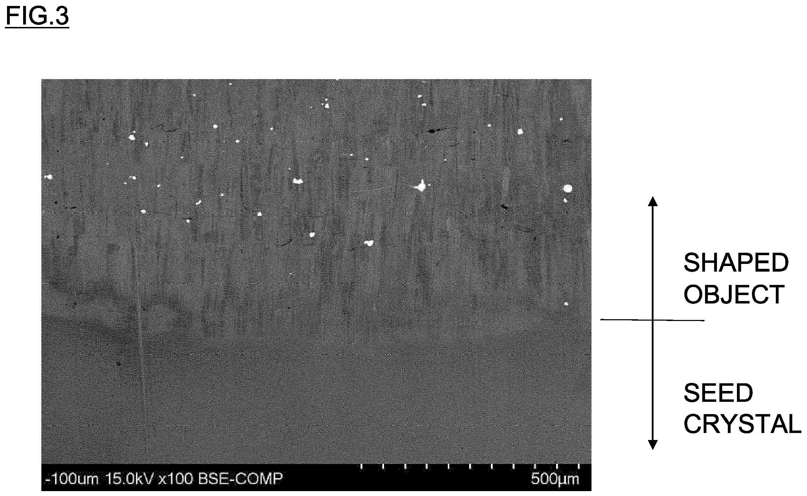

After the setting, laminating was performed on the seed crystal 102 by a selective laser melting (SLM) method. FIG. 3 illustrates a sectional structure of a boundary-between a shaped object obtained in Example 1 and the seed crystal. As illustrated in FIG. 3, a crystal of the shaped object and the seed crystal are in the same direction. Thereby, as illustrated in FIG. 2, it became obvious that the shaped object taking over the direction of the seed crystal 102 can be obtained by controlling the scan direction SD of the energy beam 103 and the direction of the seed crystal 102, without making the surface of the seed crystal 102 and the base 101 at the same level.

### (Example 2)

In Example 2, similarly to Example 1, a material having the metal composition shown in Table 1 was used as shaping powder. Additionally, a single crystal material having the same composition as that of the shaping powder was used as a seed crystal.

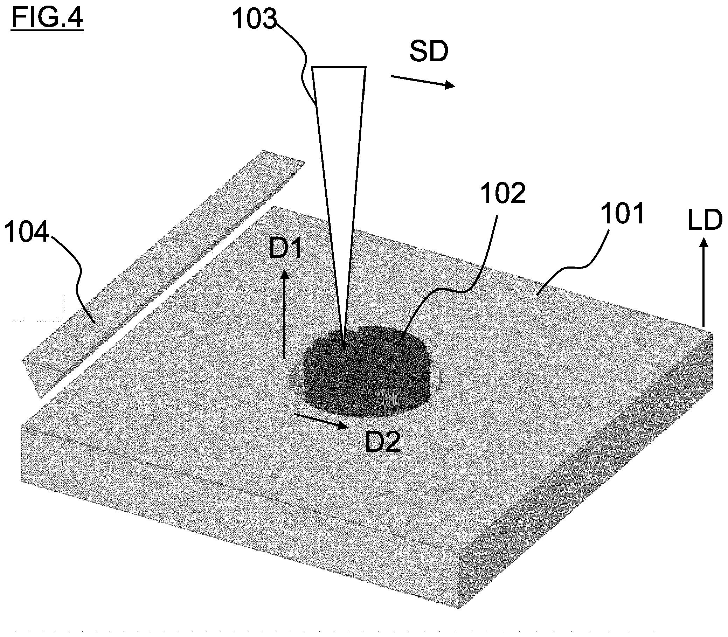

Here, a direction of a seed crystal 102 was measured in advance by a back-reflection Laue method. Then, as schematically illustrated in FIG. 4, the seed crystal 102 was embedded on a base 101 in a manner that a first direction D1 (for example, a direction [001]) along <001> of the seed crystal 102 became a lamination direction LD and that a second direction D2 (for example, a direction [010] or a direction [100]) being <001> orthogonal to the first direction D1 of the seed crystal was in parallel to a scan direction SD of an energy beam 103. When the seed crystal 102 was embedded, the seed crystal 102 was set in a manner that an upper surface of the seed crystal 102 was in parallel to a base 101 plane and was higher than the surface of the base 101 by 100 µm.

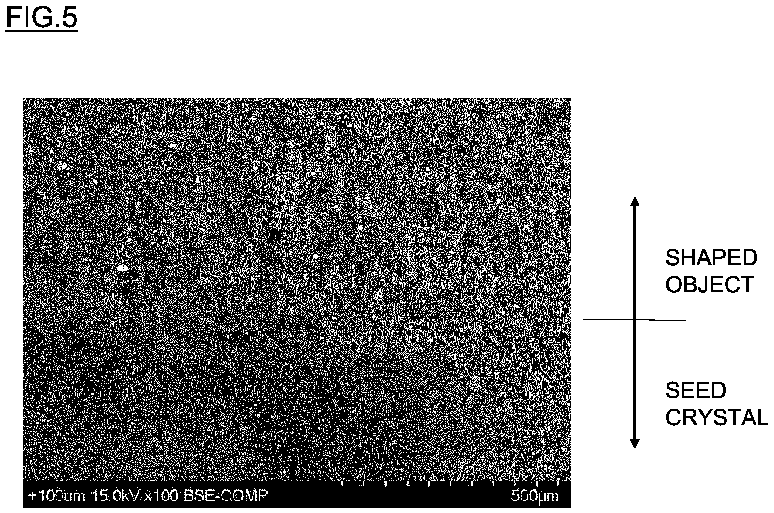

After the setting, laminating was performed on the seed crystal by a selective laser melting (SLM) method. FIG. 5 illustrates a sectional structure of a boundary-between a shaped object obtained in Example 2 and the seed crystal. As illustrated in FIG. 5, a crystal of the shaped object and the seed crystal are in the same direction. Thereby, as illustrated in FIG. 4, it became obvious that the shaped object taking over the direction of the seed crystal 102 can be obtained by controlling the scan direction SD of the energy beam 103 and the direction of the seed crystal 102, without making the surface of the seed crystal 102 and the base 101 at the same level.

### (Example 3)

In Example 3, similarly to Example 1, a material having the metal composition shown in Table 1 was used as shaping powder. Additionally, a single crystal material having the same composition as that of the shaping powder was used as a seed crystal.

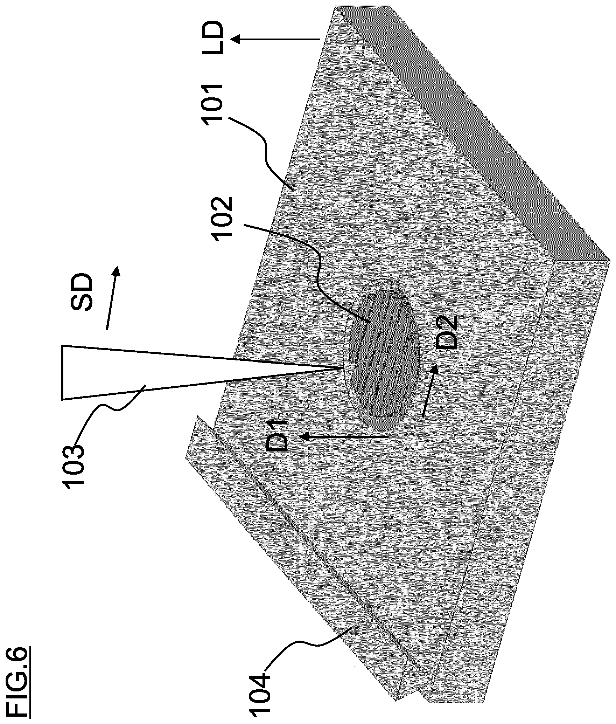

Here, a direction of a seed crystal 102 was measured in advance by a back-reflection Laue method. Then, as schematically illustrated in FIG. 6, the seed crystal 102 was embedded on a base 101 in a manner that a first direction D1 (for example, a direction [001]) along <001> of the seed crystal 102 became a lamination direction LD and that a second direction D2 (for example, a direction [010] or a direction [100]) being <001> orthogonal to the first direction D1 of the seed crystal 102 was in parallel to a scan direction SD of an energy beam 103. When the seed crystal 102 was embedded, the seed crystal 102 was set in a manner that an upper surface of the seed crystal 102 was in parallel to a base 101 plane and was lower than the surface of the base 101 by 20 µm.

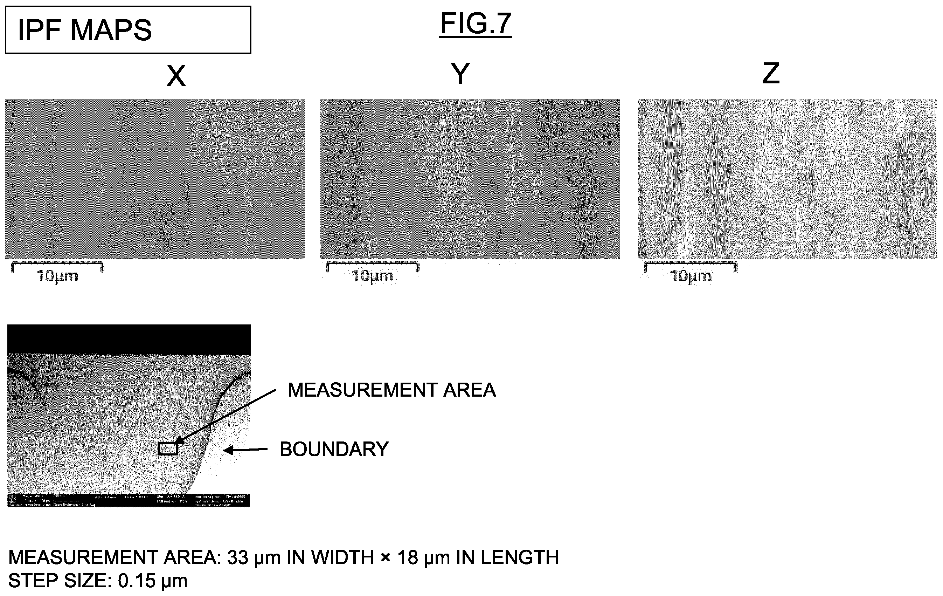

After the setting, laminating was performed on the seed crystal by a selective laser melting (SLM) method. FIGS. 7 illustrate EBSP-IPF maps showing crystal directions of a boundary-between a shaped object obtained in Example 3 and the seed crystal. As illustrated in FIGS. 7, a crystal of the shaped object and the seed crystal are in the same direction. Thereby, as illustrated in FIG. 6, it became obvious that the shaped object taking over the direction of the seed crystal 102 can be obtained by controlling the scan direction SD of the energy beam 103 and the direction of the seed crystal 102, without making the surface of the seed crystal 102 and the base 101 at the same level.

### (Comparative Example)

In Comparative Example, similarly to Examples 1 to 3, a material having the metal composition shown in Table 1 was used as shaping powder, and a single crystal material having the same composition as that of the shaping powder was used as a seed crystal.

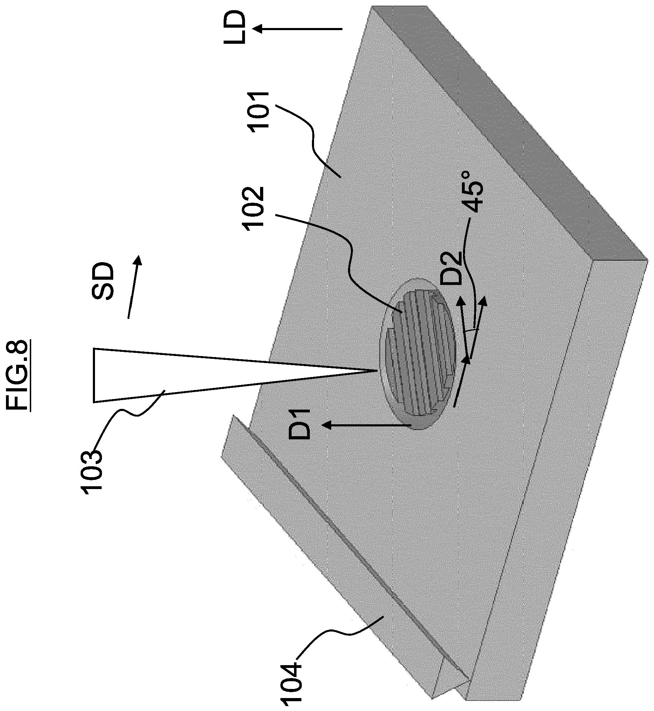

Here, a direction of a seed crystal 102 was measured in advance by a back-reflection Laue method. Then, as schematically illustrated in FIG. 8, the seed crystal 102 was embedded on a base 101 in a manner that a first direction D1 (for example, a direction [001]) along <001> of the seed crystal 102 became a lamination direction LD and that a second direction D2 (for example, a direction [010] or a direction [100]) being <001> orthogonal to the first direction D1 of the seed crystal 102 had an angle of 45 degrees in relation to a scan direction SD of an energy beam 103. When the seed crystal 102 was embedded, the seed crystal 102 was set in a manner that an upper surface of the seed crystal 102 was in parallel to a base 101 plane and was lower than the surface of the base 101 by 20 µm.

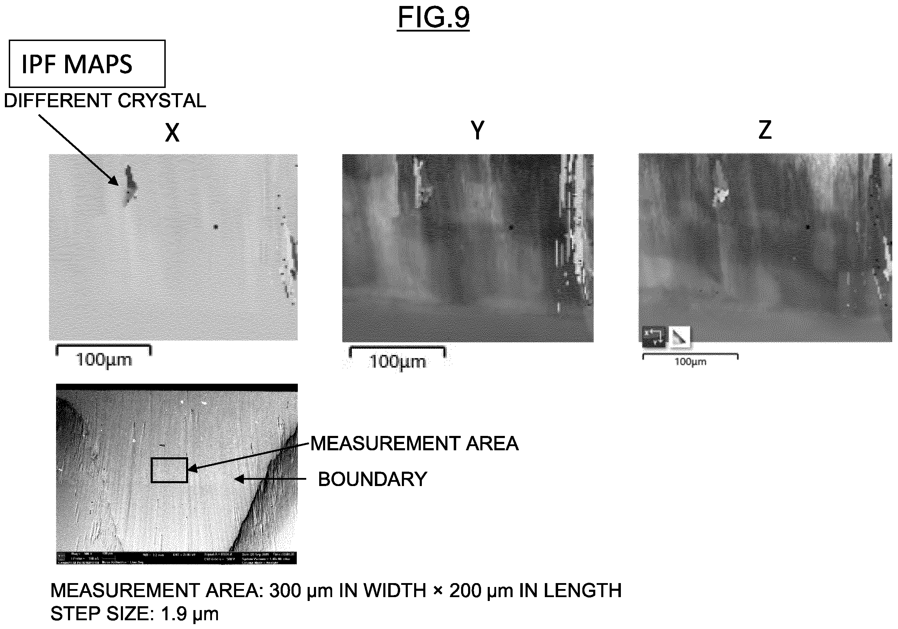

After the setting, laminating was performed on the seed crystal by a selective laser melting (SLM) method. FIGS. 9 illustrate EBSP-IPF maps showing crystal directions of a boundary-between a shaped object obtained in Comparative Example and the seed crystal. As illustrated in FIGS. 9, though there is a region of a single crystal, generation of a different crystal is recognized. Thereby, it is found that crystal growth in Comparative Example is inferior to that of Examples 1 to 3.

In Example 1 to Example 3, there was explained a case where the first direction D1 of the seed crystal 102 was in parallel to the lamination direction LD and also the second direction D2 of the seed crystal 102 was in parallel to the scan direction SD of the energy beam 103. However, a similar result to that of Example 1 to Example 3 can be obtained also in a case where a first direction D1 of a seed crystal 102 is inclined in an angle within 15 degrees in absolute value (in other words, in an angle within +15 degrees and -15 degrees) in relation to a lamination direction LD and a second direction D2 of the seed crystal 102 is inclined in an angle within 20 degrees in absolute value (in other words, in an angle within +20 degrees and -20 degrees) in relation to a scan direction SD of an energy beam 103.

While certain embodiments of the present invention have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

### EXPLANATION OF CODES

101 ...... base, 102 ...... seed crystal, 103 ...... energy beam (laser beam), 104 ...... recoater, D1 ... ... first direction, LD ... ... laminating direction, D2 ...... second direction, SD ...... scanning direction

## Claims

1. A method for manufacturing a turbine component in which the turbine component is manufactured by laminating shaped layers on a surface of a base in a laminating direction, the method comprising:
a seed crystal placing step in which a seed crystal is placed on the surface of the base; and
a shaped layer forming step in which after powder of a constituent constituting the shaped layer is put on the surface of the base to cover the seed crystal, an energy beam is irradiated to the powder put on the surface of the base by scanning in a scan direction to thereby form the shaped layer, wherein
the seed crystal, being a single crystal, is metal having a face-centered cubic crystal structure or a structure where an L1₂ phase is coherently precipitated in a face-centered cubic crystal,
in the seed crystal placing step, the seed crystal is placed on the surface of the base in a manner that a first direction along <001> of the seed crystal has an angle within 15 degrees in absolute value in relation to the laminating direction, and
in the shaped layer forming step, scanning by the energy beam is performed in a manner that the scan direction has an angle within 20 degrees in absolute value in relation to a second direction being <001> orthogonal to the first direction of the seed crystal.

2. The method for manufacturing the turbine component according to claim 1, wherein
in the seed crystal placing step, the seed crystal is placed on the surface of the base in a manner that the first direction has an angle within 5 degrees in relation to the laminating direction.

3. The method for manufacturing the turbine component according to claim 1 or 2, wherein
in the shaped layer forming step, scanning is performed in a manner that the scan direction has an angle within 10 degrees in relation to the second direction.

4. The method for manufacturing the turbine component according to any one of claims 1 to 3, wherein
the powder is made of a nickel-based alloy.

5. The method for manufacturing the turbine component according to any one of claims 1 to 4, wherein
a material of the seed crystal is a nickel-based alloy.

6. The method for manufacturing the turbine component according to any one of claims 1 to 5, wherein
the seed crystal is placed on the base in a manner that an upper surface of the seed crystal is lower than the base surface to thereby obtain a shaped product taking over a crystal direction of the seed crystal.

7. The method for manufacturing the turbine component according to any one of claims 1 to 6, wherein
the energy beam is a laser beam.

8. A turbine component manufactured by the method for manufacturing the turbine component according to any one of claims 1 to 7.

9. A method for repairing a turbine component in which the turbine component is repaired by laminating shaped layers on a surface of the turbine component in a laminating direction, the method comprising:
a seed crystal placing step in which a seed crystal is placed on a surface of a portion to be repaired in the turbine component; and
a shaped layer forming step in which after powder of a constituent constituting the shaped layer is put on the surface to cover the seed crystal, an energy beam is irradiated to the powder put on the surface by scanning in a scan direction to thereby form the shaped layer, wherein
the seed crystal, being a single crystal, is metal having a face-centered cubic crystal structure or a structure where an L1₂ phase is coherently precipitated in a face-centered cubic crystal,
in the seed crystal placing step, the seed crystal is placed on the surface of the base in a manner that a first direction along <001> of the seed crystal has an angle within 15 degrees in absolute value in relation to the laminating direction, and
in the shaped layer forming step, scanning by the energy beam is performed in a manner that the scan direction has an angle within 20 degrees in absolute value in relation to a second direction being <001> orthogonal to the first direction of the seed crystal.
